# EUROPÄISCHE PATENTSCHRIFT

(11) **EP 0 285 928 B1**
(45) Veröffentlichungstag und Bekanntmachung des Hinweises auf die Patenterteilung: **15.12.1993**
(21) Anmeldenummer: 88104813.6
(22) Anmeldetag: 25.03.1988
(51) Int. Cl.: H01H 13/70

(54) **Taste für eine Werteingabetastatur**
Push-button for a data input keyboard
Touche pour un clavier d'entrée de données

(30) Priorität: 07.04.1987 DE 8705193 U
(43) Veröffentlichungstag der Anmeldung: 12.10.1988
(73) Patentinhaber: Digital-Kienzle Computersysteme GmbH & Co. KG, 78048 Villingen-Schwenningen (DE)
(72) Erfinder: Zumkeller, Oskar, 7730 Villingen-Schwenningen (DE); Fesenmeier, Hugo, 7715 Bräunlingen (DE)
(74) Vertreter: Leiser, Gottfried, Dipl.-Ing.

(56) Entgegenhaltungen:
- EP-A- 0 122 128
- DE-U- 8 707 707
- GB-A- 2 046 996

## Beschreibung

Die Erfindung betrifft eine Taste für eine Werteingabetastatur mit einem Tastensockel, an welchem einerseits eine Führungshülse angeformt, andererseits Rastmittel ausgebildet sind, die dem Befestigen des Tastensockels an einer Leiterplatte dienen, mit einem Tastenkopf, an welchem ein der Führungshülse zugeordneter Schaft angeformt ist, mit einer Druckfeder, welche zwischen dem Tastensockel und dem Tastenkopf wirksam ist, und mit Anschlagmitteln, welche den Hub der Taste im nicht betätigten Zustand begrenzen.

Bei einer Vielzahl von Datenerfassungs- und Datenverarbeitungsgeräten sind Werteingabetastaturen, wie z. B. Zehner-Tastaturen, alphanumerische Tastaturen oder Funktionstastaturen entweder als eigenständige Baugruppen integriert, oder in zunehmendem Maße auch als Einzelaggregate frei beweglich zugeordnet.

Forderungen nach fehlersicherer Bedienbarkeit der jeweiligen Tastaturen, ergonomischer Gestaltung der Tastenköpfe, geometrischer Optimierung und Vereinheitlichung der Tastenkonfigurationen und einer möglichst flachen Bauweise führen zu einer weitgehenden Standardisierung und somit zu hohen Stückzahlen, einer Voraussetzung für Großserienfertigung und maschinelle Montage.

Das bevorzugte bauliche Konzept derartiger Tastaturen sieht vor, auf einer der jeweiligen Tastatur als Träger dienenden Leiterplatte funktionsfertige Einzeltasten, vorzugsweise durch geeignete Schnappverbindungen, zu montieren. Ein solches Konzept erleichtert den Aufbau beliebiger Tastenkonfigurationen sowie deren Änderung, wirkt sich positiv aus bei Reparaturen und ist auch noch bei kleinen Serien wirtschaftlich. (Siehe Z.B. GB-A-2 046 996).

Die Großserienfertigung und insbesondere eine maschinelle Montage von Tastaturen erfordert jedoch zusätzlich, daß die betreffende Tastatur mit möglichst wenig Arbeitsgängen und formtechnisch relativ einfachen Bauteilen gefertigt wird und die Montage ohne nachträgliches Justieren erfolgen kann, und zwar mit einer hohen Reproduzierbarkeit bezüglich der Ausrichtung der einzelnen Tasten zueinander, wobei bisher übliche Fertigungstoleranzen und Funktionsspiel zwischen Tastensockel und Tastenkopf wegen der Kunststoff-Führung zwischen den beiden Bauteilen im allgemeinen nicht verringert werden können. Dabei handelt es sich nicht nur um die möglichst exakte Ausrichtung der Tastensockel der einzelnen Tasten, sondern insbesondere auch um eine jeweils gleiche Stellung der Tastenköpfe bzw. deren Griffflächen im unbetätigten Zustand. Dies ist insbesondere dann unumgänglich, wenn Tastaturen berührungslos, beispielsweise mit Hilfe eines Laser- oder ähnlichen Energiestrahls bedruckt werden sollen.

Aufgabe der vorliegenden Neuerung war es somit, eine Tastenarchitektur zu schaffen, die den Anforderungen der Großserienfertigung gerecht wird und die bei Großserien üblichen Toleranzen eine optimalen Ausrichtung von zu einer Tastatur zusammengefügten Einzeltasten gestattet.

Die Lösung dieser Aufgabe (Siehe Anspruch) sieht vor, daß die auf der Gegenseite der Führungshülse am Tastensockel vorgesehenen Rastmittel zentrisch zur Durchgangsöffnung der Führungshülse ausgebildet sind, daß an der Seite des Tastensockels, an der die Rastmittel ausgebildet sind, ein Zapfen angeformt ist, daß der Schaft geschlitzt ist und wenigstens an einem der durch das Schlitzen gebildeten federnden Schaftabschnitte eine mit einer am Tastensockel ausgebildeten Anschlagfläche zusammenwirkende Nase radial angeformt ist, daß an dem Tastenkopf parallel zum Schaft ein Finger ausgebildet ist und daß in dem am Tastensockel vorgesehenen Zapfen eine dem Finger zugeordnete Führungsöffnung angebracht ist.

Die erfindungsgemäße Taste bietet den Vorteil, daß sie, von den Mitteln zur Signalgabe abgesehen, aus lediglich drei Bauteilen, einem Tastensockel, einem Tastenkopf und einer Druckfeder, zusammengefügt werden kann. Ein weiterer Vorteil besteht darin daß infolge der zentrisch zur Führungshülse am Tastensockel angeordneten Rastelemente, denen als Verdrehsicherung in einem möglichst großen Abstand ein Zapfen zugeordnet ist, zur Befestigung der Taste auf einer Leiterplatte sowie für das Durchgreifen des Schaftes des Tastenkopfes durch die Leiterplatte, was - bedingt durch den flachen Aufbau -aufgrund der Führungsgenauigkeit erforderlich ist, in der Leiterplatte lediglich zwei Bohrungen benötigt werden. Ferner bietet die Lösung, den Tastenkopf mittels am Schaft angeformter Nasen zu arretieren, den Vorteil, daß der Tastenkopf in der Wirkungslinie der Federkraft arretiert wird und somit, ohne daß ein nennenswertes Kippmoment entsteht, bei entsprechender Formgebung der bei der Arretierung zusammenwirkenden Flächen eine Zentrierung des Tastenkopfes erfolgt. Auf diese Weise wird eine exakte, weitgehend spielfreie Endstellung des Tastenkopfes erreicht und eine Schieflage der Grifflächen vermieden.

Durch diese Maßnahme wird letzten Endes aber auch ermöglicht, daß die Taste flacher ausgebildet und mit einem Minimum an Bauteilen zusammengefügt werden kann, da in herkömmlicher Weise am Sockel angeformte Riegel bzw. Rasthaken, denen geeignete, durch eine Tastenkappe abdeckbare Aussparungen im Tastenkopf zugeordnet sein müssen, entfallen. Damit wird selbstverständlich auch innerhalb des Tastenkopfes Raum gewonnen, der z. B. für ein Lager eines der Führung einer Doppel- oder Langtaste dienenden Bügels benutzt werden kann. Bei der Einzeltaste ist dieses Lager ohne Funktion. Einer Doppeltaste beispielsweise, bei der ein Führungsbügel erforderlich ist, werden die Sockel zweier Einzeltasten zugeordnet, d. h. es wird vermieden, daß für Einzel- und Doppeltaste unterschiedliche Sockel gefertigt und gehandhabt werden müssen.

Bei der erfindungsgemäßen Arretierung des Tastenkopfes ist es selbstverständlich erforderlich, auch den Tastenkopf mit einer wirksamen Verdrehsicherung auszustatten. Die gefundene Lösung, einen zum Schaft exzentrisch am Tastenkopf angeformten Finger in eine in dem am Tastensockel ausgebildeten Zapfen angebrachte Öffnung eingreifen zu lassen, vermeidet eine zusätzliche Öffnung in der Leiterplatte. Die Verdrehsicherung des Tastensockels wird vom Tastenkopf sozusagen "mitbenutzt". Erwähnenswert ist ferner, daß der formtechnische Aufwand für die Fertigung von Sockel und Tastenkopf relativ gering ist, jedenfalls seitliche Schieber vermieden sind.

Im folgenden sei eine bevorzugte Ausgestaltung der Erfindung anhand der beigefügten Zeichnungen näher erläutert. Es zeigen
FIGUR 1 eine Explosionsdarstellung der neuerungsgemäßen Taste in Zuordnung zu einer Leiterplatte,
FIGUR 2 einen Ausschnitt einer teilweise montierten Tastatur in Draufsicht.

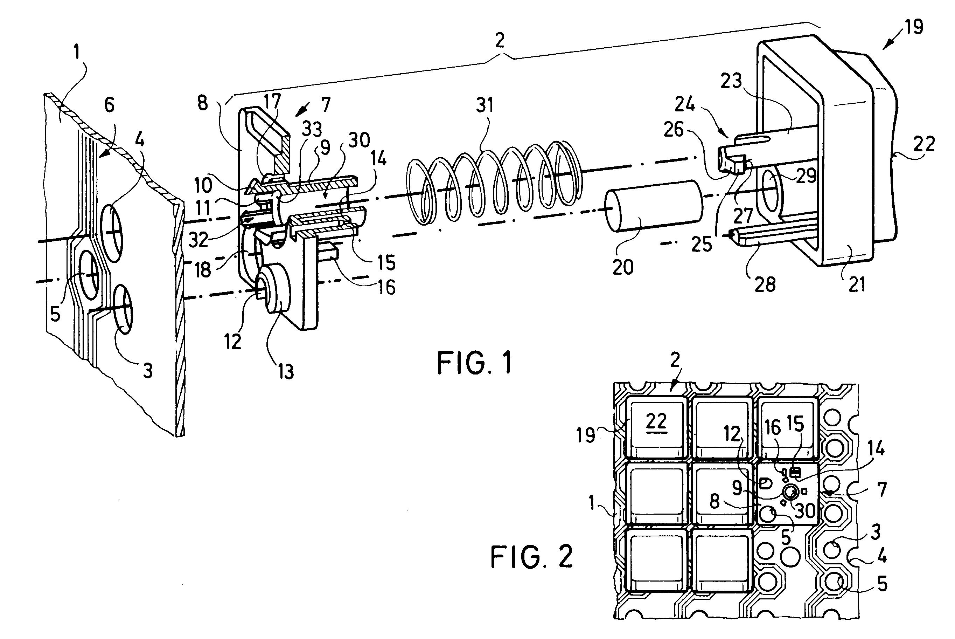

In der Explosionsdarstellung FIGUR 1 ist mit 1 ein Leiterplattenausschnitt bezeichnet, in welchem der Taste 2 zugeordnete Bohrungen 3, 4 und 5 angebracht sind. Mit 6 sind sich kreuzende, beidseitig an der Leiterplatte 1 aufgebrachte Leiterbahnen bezeichnet, die, was nicht neuheitswesentlich ist, aber der Vollständigkeit halber erwähnt sei, zusammen mit der Bohrung 5 eine Induktionsspule bilden, d. h. bei dem gewählten Ausführungsbeispiel erfolgt die Signalgabe induktiv.

Die FIGUR 1 zeigt ferner einen Tastensockel 7, im wesentlichen bestehend aus einer flachen Platte 8, an welcher einerseits eine Führungshülse 9, andererseits zentrisch zur Führungshülse 9 Rasthaken und Zentriernasen, von denen jeweils einer bzw. eine mit 10 und 11 bezeichnet ist, angeformt sind. Gleichseitig mit den Rasthaken 10 und den Zentriernasen 11 ist ein mit einer Öffnung 12 versehener Zapfen 13 ausgebildet. Federnde Backen 14 und 15 sowie eine Auflage 16 sind als Lager für den Führungsbügel einer Doppel- oder Langtaste vorgesehen. Eine zylindrische Senkung 17 dient der Vergrößerung der Federlänge der Rasthaken 10, während eine Öffnung 18 als Freisparung für den Durchtritt eines bei Tastenbetätigung in die Bohrung 5 der Leiterplatte 1 eintauchenden und im Tastenkopf 19 gehalterten Ferritkerns 20 vorgesehen ist.

Der Tastenkopf 19 stellt einen im wesentlichen einseitig offenen Hohlkörper 21 dar, dessen eine Seite - je nach Anwendungsfall - in geeigneter Weise strukturiert und mit einer Grifffläche 22 versehen ist. Ein an dem Hohlkörper 21 angeformter Schaft 23 ist mit einem axial gerichteten Schlitz 24 versehen. An dem einen durch den Schlitz 24 geschaffenen Schaftabschnitt ist eine radial gerichtete Nase 25 mit in Achsrichtung des Schaftes 23 angeschrägten Flächer 26 und 27 angeformt. Ferner ist parallel zum Schaft 23 am Hohlkörper 21 ein Finger 28 derart angeformt, daß er beim Zusammenfügen von Tastensockel 7 und Tastenkopf 19 in die Öffnung 12 des Tastensockels 7 eingreift und in dieser geführt ist. Eine Sacköffnung 29 dient dem Ferritkern 20 als Aufnahme, mit 30 ist die Durchgangsöffnung in der Führungshülse 9 bezeichnet.

Die Montage der Taste 2 auf der Leiterplatte 1 erfolgt, wie auch aus FIGUR 2 ersichtlich ist, vorzugsweise im Folgeverfahren, d. h. es wird zunächst der Tastensockel 7 in der Leiterplatte 1 verrastet, wobei die Rasthaken 1o durch die Öffnung 4 hindurch die Leiterplatte 1 hintergreifen und der Zapfen 13 in die Öffnung 3 eingreift. Danach wird eine Druckfeder 31 auf die Hülse 9 gesteckt und der Tastenkopf 19, an dem der Ferritkern 2o vormontiert ist, derart aufgesetzt, daß der Finger 28 in der im Zapfen 13 befindlichen Öffnung 12 geführt ist und die am Schaft 23 angeformte Nase 25 in eine der Durchgangsöffnung 30 zugeordnete Freisenkung 32 einrastet. In der End- bzw. unbetätigten Stellung der Taste 2 wirken dann die angeschrägte Fläche 27 der Nase 25 und eine zwischen der Durchgangsöffnung 3o und der Freisenkung 32 sich ergebende, vorzugsweise konisch gestaltete, ringförmige Anschlagfläche 33 zusammen.

Zur Verbesserung der Zentrierung ist es denkbar, das Ende des Schaftes 23 beispielsweise in drei federnde Abschnitte, an denen geeignete Rastelemente angeformt sind, aufzuteilen. Ferner sei erwähnt, daß die Führungshülse 9 in bezug auf die im wesentlichen quadratische Platte 8 des Tastensockels 7 um ein gewisses Maß diagonal versetzt sein kann und daß der Zapfen 13 mit dem größtmöglichen Abstand zur Führungshülse 9 auf der gleichen Diagonalen angeformt wird. Eine besonders aufwandminimierte Lösung läßt sich für eine induktive Tastatur außerdem dadurch erreichen, daß der Ferritkern in einer zentralen Öffnung im Schaft des Tastenkopfes 19 aufgenommen wird. Bei dieser Lösung sind dann nur noch zwei Öffnungen in der Leiterplatte 1 erforderlich.

## Patentansprüche

1. Taste für eine Werteingabetastatur, mit einem Tastensockel (7), an welchem einerseits eine Führungshülse (9) angeformt, andererseits Rastmittel (10, 11) ausgebildet sind, die dem Befestigen des Tastensockels an einer Leiterplatte (1) dienen,
mit einem Tastenkopf (19), an welchem ein der Führungshülse zugeordneter Schaft (23) angeformt ist,
mit einer Druckfeder (31), welche zwischen dem Tastensockel und dem Tastenkopf wirksam ist und
mit Anschlagmitteln (25), welche den Hub der Taste im nicht betätigten Zustand begrenzen,
dadurch gekennzeichnet,
daß die auf der Gegenseite der Führungshülse (9) am Tastensockel (7) vorgesehenen Rastmittel (1o, 11) zentrisch zur Durchgangsöffnung (3o) der Führungshülse (9) ausgebildet sind,
daß an der Seite des Tastensockels (7), an der die Rastmittel (1o, 11) ausgebildet sind, ein Zapfen (13) angeformt ist,
daß der Schaft (23) geschlitzt ist und wenigstens an einem der durch das Schlitzen gebildeten, federnden Schaftabschnitte eine mit einer am Tastensockel (7) ausgebildeten Anschlagfläche (33) zusammenwirkende Nase (25) radial angeformt ist,
daß an dem Tastenkopf (19) parallel zum Schaft (23) ein Finger (28) ausgebildet ist und
daß in dem am Tastensockel (7) vorgesehenen Zapfen (13) eine dem Finger (28) zugeordnete Führungsöffnung (12) angebracht ist.

## Claims

1. A key for a value introduction keyboard, comprising a key base (7) integrally moulded with a guide sleeve (9) and, on the other hand, formed with latching means (10, 11) for fixing the key base on a circuit board (1), with a key cap (19) integrally moulded with a shaft (23) associated with the guide sleeve, a compression spring (31) acting between the key base and the key cap, and abutment means (25) which limit the stroke of the key in its non-actuated state,
characterized in that
the latching means (10, 11) provided on the opposite side of the guide sleeve (9) on the key base (7) are formed centrally with respect to the through-passage (30) of the guide sleeve (9), that a stud (13) is moulded to the side of the key base (7) where the latching means (10, 11) are formed, that the shaft (23) is slotted, and that a nose (25) cooperating with an abutment face (33) formed on the key base (7) is radially moulded to one of the resilient shaft sections formed by said slotting, that a finger (28) is formed on the key cap (19) in parallel to the shaft (23) and in that a guide opening (12) associated with said finger (28) is arranged in said stud (13) provided on the key base (7).

## Revendications

1. Touche pour clavier de saisie de donnée, avec un socle de touche (7) sur lequel sont formés, d'un côté une douille de guidage (9), de l'autre côté des moyens de retenue (10, 11) qui servent à fixer le socle de touche à une plaque à conducteurs (1), avec une tête de touche (19) sur laquelle est formée une tige (23) associée à la douille de guidage, avec un ressort de poussée (31) qui agit entre le socle de touche et la tête de touche, et avec des moyens de butée (25) qui délimitent la course de la touche à l'état inactivé,
caractérisée en ce que:
les moyens de retenue (10, 11) prévus sur le socle de touche (7) du côté opposé à la douille de guidage (9) sont centrés sur l'ouverture traversante (30) de la douille de guidage (9),
un tenon (13) est formé sur le côté du socle de touche (7) sur lequel sont situés les moyens de retenue (10, 11),
la tige (23) est fendue et un taquet (25) coopérant avec une surface de retenue (33) ménagée sur le socle de touche (7) est formé radialement sur au moins l'une des portions élastiques de tige formées par la fente,
un doigt (28) est formé sur la tête de touche (19) parallèlement à la tige (23), et
dans le tenon (13) prévu sur le socle de touche (7) est ménagée une ouverture de guidage (12) correspondant au doigt (28).
